# EUROPEAN PATENT APPLICATION

(11) **EP 4 539 616 A1**
(43) Date of publication of application: **16.04.2025**
(21) Application number: 22945136.4
(22) Date of filing: 09.06.2022
(51) Int. Cl.: H05K 1/18, H01G 2/02

(54) **ELECTRONIC UNIT**

(71) Applicant: NISSAN MOTOR CO., LTD., Kanagawa 221-0023 (JP)
(72) Inventor: NATSUNO, Mihiro, Atsugi-shi, Kanagawa 243-0123 (JP); ISHIBASHI, Kenichi, Atsugi-shi, Kanagawa 243-0123 (JP); NAGAI, Keita, Atsugi-shi, Kanagawa 243-0123 (JP)
(74) Representative: Hoefer & Partner Patentanwälte mbB
(86) International application number: PCT/JP2022/023361
(87) International publication number: WO 2023/238349

(57) **Abstract**

An electronic unit to be mounted on a vehicle, the electronic unit including: a printed board to which a plurality of electronic components are attached; a capacitor which is one of the electronic components and is longer in a vertical direction perpendicular to a surface of the printed board than in a lateral direction parallel to the surface of the printed board in a state of being attached to the printed board; and a pedestal interposed between the capacitor and the printed board and configured to support the capacitor, wherein the capacitor and the pedestal are adhered by an adhesive on an outer peripheral surface of the capacitor and an inner peripheral surface of the pedestal which are perpendicular to the surface of the printed board.

## Description

### TECHNICAL FIELD

The present invention relates to an electronic unit to be mounted on a vehicle.

### BACKGROUND ART

JP2000-100651A relates to an electrode plate to be used in an inverter circuit or the like, and discloses an electrode plate in which a capacitor is connected more firmly by projection welding a terminal of the capacitor to a plate electrode than in a case of connection by soldering or screwing.

### SUMMARY OF INVENTION

In an electronic unit to be mounted on a vehicle, one or more capacitors are used as necessary. Such an electronic unit is inevitably affected by vibration generated by a rotating electric machine or the like included in the vehicle or vibration generated by a road surface on which the vehicle travels.

In particular, a capacitor, which is a tall electronic component having a relatively large protruding length from a printed board, may be broken or the like, due to the vibration, at a lead portion where a main body portion of the capacitor and the printed board are electrically connected. Such breakage of the capacitor occurs at a portion where stress tends to concentrate due to vibration of the main body portion, such as a base end of the lead portion (connection end with main body portion) or a connection portion with the printed board. Therefore, even when a tip end of the lead portion is welded to the printed board, the capacitor may be broken.

In a capacitor module such as a smoothing capacitor constituting one large-capacity capacitor by a plurality of capacitors, even though each capacitor can be projected and welded to an electrode plate, it is usually difficult to provide a structure for performing projection welding to a capacitor mounted on a printed board. Accordingly, in an electronic unit in which a capacitor is mounted on a printed board, the capacitor is easily broken by vibration.

An object of the present invention is to provide an electronic unit in which a capacitor is less likely to be broken due to vibration generated by a rotating electric machine, a road surface, or the like.

An aspect of the present invention is an electronic unit to be mounted on a vehicle. The electronic unit includes: a printed board to which a plurality of electronic components are attached; a capacitor which is one of the electronic components and is longer in a vertical direction perpendicular to a surface of the printed board than in a lateral direction, which is a surface direction of the printed board, in a state of being attached to the printed board; and a pedestal interposed between the capacitor and the printed board and configured to support the capacitor. The capacitor and the pedestal are adhered by an adhesive on an outer peripheral surface of the capacitor and an inner peripheral surface of the pedestal which are perpendicular to the surface of the printed board.

### BRIEF DESCRIPTION OF DRAWINGS

[FIG. 1] FIG. 1 is a view illustrating a schematic configuration of an electric vehicle.
[FIG. 2] FIG. 2 is an external perspective view of a first drive unit.
[FIG. 3] FIG. 3 is a view illustrating a configuration of an electronic circuit.
[FIG. 4] FIG. 4 is a perspective view illustrating a typical configuration of a pedestal.
[FIG. 5] FIG. 5 is a view illustrating a relation between adjacent electronic components and an adhesive portion between a capacitor and a pedestal.
[FIG. 6] FIG. 6 is a sectional view of a first drive unit illustrating a positional relation between a fastening point and the capacitor.

### DESCRIPTION OF EMBODIMENTS

Hereinafter, embodiments of the present invention will be described with reference to the drawings.

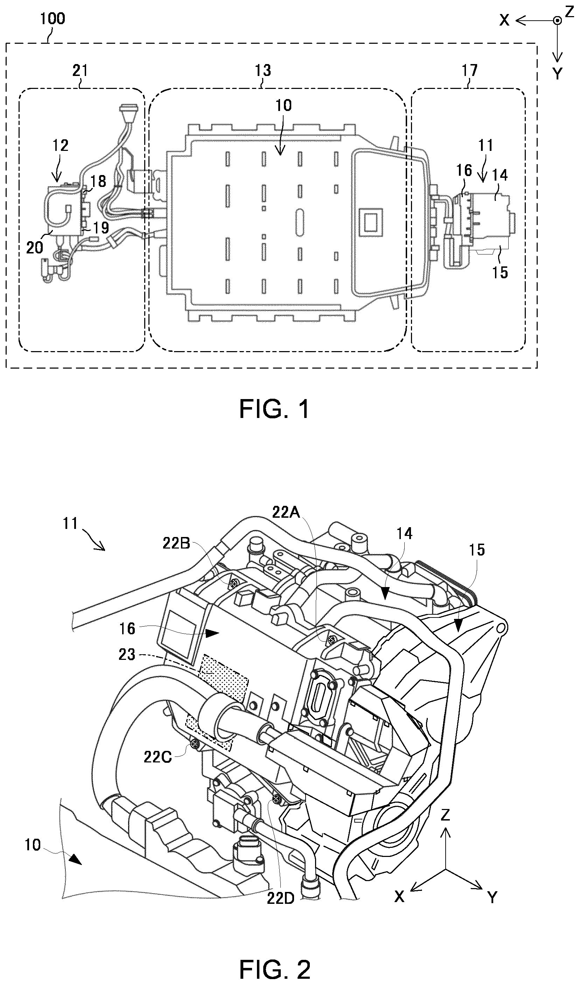

FIG. 1 is a view illustrating a schematic configuration of an electric vehicle 100. As illustrated in FIG. 1, a vehicle exemplified in the present embodiment is the electric vehicle 100, and includes a battery unit 10, a first drive unit 11, and a second drive unit 12.

Hereinafter, a front-rear direction of the electric vehicle 100 is defined as an X direction, a lateral direction is defined as a Y direction, and an upper-lower direction (height direction) is defined as a Z direction. More specifically, a positive side in the X direction is the front of the electric vehicle 100, and a negative side in the X direction is the rear of the electric vehicle 100. A positive side in the Y direction is the left of the electric vehicle 100, and a negative side in the Y direction is the right of the electric vehicle 100. A positive side in the Z direction is above the electric vehicle 100, and a negative side in the Z direction is below the electric vehicle 100. In principle, an XY plane is a horizontal plane, and the Z direction is a vertical direction. In the present embodiment, inclination of a road surface is not considered for the sake of simplicity. Therefore, any direction in the horizontal plane (XY plane) is a horizontal direction (road surface direction). The positive side in the Z direction is vertically above, and the negative side in the Z direction is vertically below.

The battery unit 10 includes one or a plurality of batteries that store electric power for driving the electric vehicle 100. In the present embodiment, since the electric vehicle 100 includes two drive units, that is, the first drive unit 11 and the second drive unit 12, the battery unit 10 supplies electric power to each of the drive units. In the present embodiment, the battery unit 10 is disposed substantially under a floor of a vehicle cabin 13.

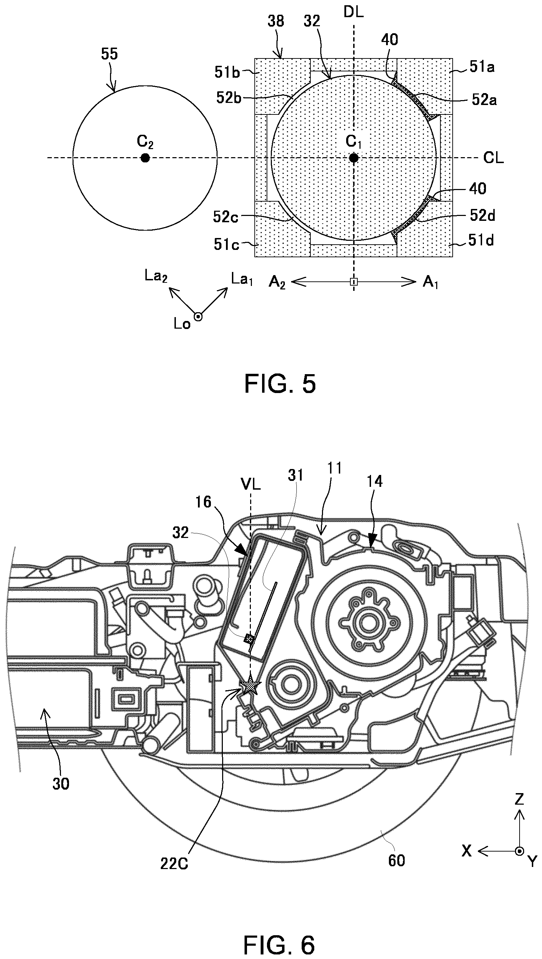

The first drive unit 11 is a drive unit in which an electric motor 14, a speed reducer 15, and an inverter 16 that is an electronic unit are integrally configured, and drives a rear wheel 60 (see FIG. 6) of the electric vehicle 100 using electric power supplied from the battery unit 10. In the present embodiment, the first drive unit 11 is disposed substantially under a floor of a cargo compartment 17. Accordingly, in order to widen the cargo compartment 17 as much as possible, the inverter 16 is attached to the electric motor 14 to be inclined forward (positive side in X direction) with respect to the horizontal direction in the first drive unit 11. The speed reducer 15 may be omitted. That is, the first drive unit 11 may include the electric motor 14 and the inverter 16.

As usual, the first drive unit 11 is fixed to a suspension member via a mount bracket including an elastic bush (none of which is illustrated). When vibration occurs due to a road surface on which the electric vehicle 100 travels, the vibration is attenuated by the above configurations and transmitted (input) to the first drive unit 11. Since the electric vehicle 100 vibrates substantially in the upper-lower direction due to the road surface, vibration caused by a road surface is hereinafter referred to as vertical vibration.

The second drive unit 12 is a drive unit in which an electric motor 18, a speed reducer 19, and an inverter 20 that is an electronic unit are integrally configured, and drives a front wheel (not illustrated) of the electric vehicle 100 using electric power supplied from the battery unit 10. In the present embodiment, the second drive unit 12 is disposed in a motor room 21. Accordingly, the second drive unit 12 is disposed substantially horizontally on the electric motor 18 and the speed reducer 19. The speed reducer 19 may be omitted. That is, the second drive unit 12 may include the electric motor 18 and the inverter 20.

Similarly to the first drive unit 11, the second drive unit 12 is fixed to a suspension member via a mount bracket including an elastic bush (none of which is illustrated). Accordingly, the vertical vibration generated by the road surface is attenuated by the above configurations and transmitted (input) to the second drive unit 12.

FIG. 2 is an external perspective view of the first drive unit 11. As illustrated in FIG. 2, the inverter 16 is fixed to the electric motor 14 at four fastening points, that is, a first fastening point 22A, a second fastening point 22B, a third fastening point 22C, and a fourth fastening point 22D. Among these fastening points, the first fastening point 22A and the second fastening point 22B are relatively upper fastening points, and the third fastening point 22C and the fourth fastening point 22D are relatively lower fastening points.

In the present embodiment, the first fastening point 22A and the second fastening point 22B, which are upper fastening points, are provided at substantially the same position (height) in the vertical direction. That is, the first fastening point 22A and the second fastening point 22B are aligned in the horizontal direction (Y direction). Similarly, the third fastening point 22C and the fourth fastening point 22D, which are lower fastening points, are provided at substantially the same position (height) in the vertical direction. That is, the third fastening point 22C and the fourth fastening point 22D are aligned in the horizontal direction (Y direction). However, the third fastening point 22C and the fourth fastening point 22D are in front of (positive side in X direction) the first fastening point 22A and the second fastening point 22B.

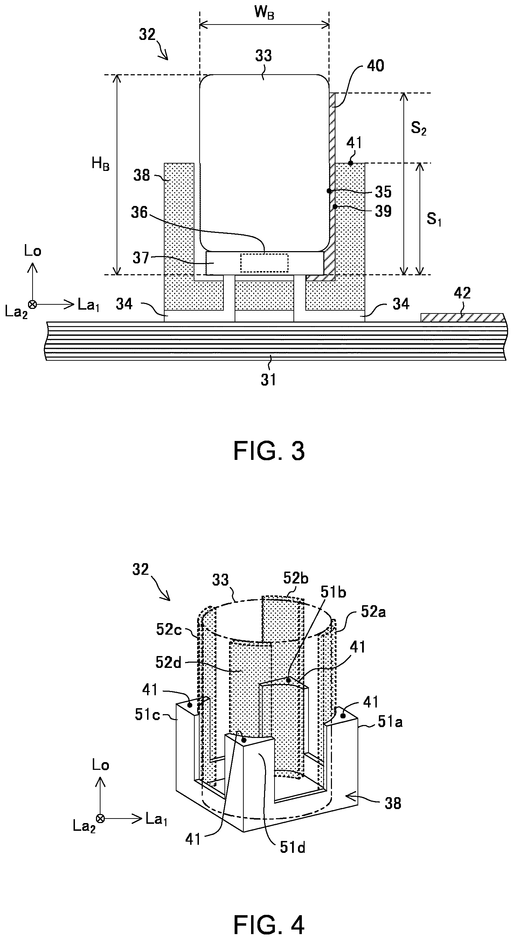

The inverter 16 includes an electronic circuit 23 including one or a plurality of capacitors 32 (see FIG. 3). As usual, the electronic circuit 23 is attached to a housing of the inverter 16 via a vibration-proof member (not illustrated). Accordingly, the vertical vibration due to the road surface and the vibration generated by the electric motor 14 (hereinafter referred to as rotational vibration) are attenuated by the vibration-proof member and transmitted (input) to the capacitor 32. The vertical vibration and the rotational vibration are transmitted from the fastening points of the inverter 16 to the capacitor 32. However, in the present embodiment, the electronic circuit 23 is particularly provided in the vicinity of the third fastening point 22C. Accordingly, the vertical vibration and the rotational vibration are substantially transmitted from the third fastening point 22C.

FIG. 3 is a view illustrating a configuration of the electronic circuit 23. As illustrated in FIG. 3, the electronic circuit 23 includes a printed board 31 and electronic components attached to the printed board 31. That is, the printed board 31 on which the electronic components are mounted is the electronic circuit 23. Examples of the electronic components mounted on the printed board 31 include an integrated circuit (IC) chip (not illustrated), the capacitor 32, a coil 55 (see FIG. 5), and a connector (not illustrated) that connects the electronic circuit 23 to an external circuit or the like. In the present embodiment, the electronic circuit 23 includes at least the capacitor 32 being mounted on the printed board 31 as the electronic component.

The printed board 31 is a flat board having wiring patterns formed in one or a plurality of layers. In the present embodiment, the printed board 31 is a rigid board, and is formed using an insulator base material having no flexibility. However, all or a part of the printed board 31 may be flexible.

Hereinafter, any direction parallel to a surface of the printed board 31 is defined as a first direction La₁, and a direction perpendicular to the first direction La₁ is defined as a second direction La₂. A direction perpendicular to the first direction La₁ and the second direction La₂ (surface of printed board 31) is defined as a third direction Lo. The surface of the printed board 31 is a surface on which electronic components such as the capacitor 32 are mounted.

A lateral direction of the electronic component refers to a direction parallel to the surface of the printed board 31, such as the first direction La₁ or the second direction La₂. A width of the electronic component refers to a length in the lateral direction. A vertical direction of the electronic component refers to the third direction Lo perpendicular to the surface of the printed board 31. A height of the electronic component refers to a length in the vertical direction. An upper surface of the electronic component refers to a surface on a positive side in the third direction Lo. A lower surface of the electronic component refers to a surface on a negative side in the third direction Lo. A side surface of the electronic component refers to a surface connecting the upper surface and the lower surface. The side surface of the electronic component is formed by, for example, a surface parallel to the third direction Lo (surface perpendicular to surface of printed board 31).

The capacitor 32 is one of the electronic components mounted on the printed board 31. In the present embodiment, the capacitor 32 is longer in a vertical direction (third direction Lo) perpendicular to the surface of the printed board 31 than in a lateral direction (for example, first direction La₁) parallel to the surface of the printed board 31 in a state of being attached to the printed board 31. That is, in the present embodiment, the capacitor 32 is a vertically long electronic component having a high height as a whole.

The capacitor 32 is, for example, a wet electrolytic capacitor. However, the capacitor 32 may be a capacitor of another form as long as it is formed in a vertically long shape. The capacitor 32 includes a main body portion 33 and a lead portion 34.

The main body portion 33 is a portion in which a cathode, an anode, an electrolytic solution, and the like are accommodated, and is configured in a substantially vertically long cylindrical shape. Specifically, a height H_{B} of the main body portion 33 is longer than a width W_{B} thereof. Accordingly, the capacitor 32 is an electronic component having a shape longer in the vertical direction than in the lateral direction as a whole, that is, a tall electronic component. A side surface forming an outer periphery of the main body portion 33 (hereinafter, referred to as outer peripheral surface 35 of capacitor 32) is formed by a substantially cylindrical curved surface.

The main body portion 33 includes an explosion-proof valve 36. The explosion-proof valve 36 is a structure for releasing gas generated inside the main body portion 33 and preventing explosion of the capacitor 32. In the present embodiment, a sealing portion 37 for sealing the electrolytic solution and the like, which is the content of the main body portion 33, is formed at a lower portion of the main body portion 33, which is an end portion on a printed board 31 side, and the explosion-proof valve 36 is formed in the sealing portion 37. However, the explosion-proof valve 36 may be formed on the upper surface of the main body portion 33.

The lead portion 34 is an electrode connected to the cathode or the anode of the main body portion 33 and protruding from the main body portion 33, and is a portion electrically connected to the wiring pattern of the printed board 31. In the present embodiment, the lead portion 34 is bent and extended in an L shape from the main body portion 33, and is electrically connected to the wiring pattern of the printed board 31 by soldering, welding, or the like at a portion parallel to the surface of the printed board 31 after the bending.

The capacitor 32 is connected to the printed board 31 via the pedestal 38. The pedestal 38 is interposed between the capacitor 32 and the printed board 31 and supports the capacitor 32. In particular, the pedestal 38 supports the outer peripheral surface 35 of the capacitor 32 in part or in whole. Accordingly, the pedestal 38 limits the inclination of the capacitor 32 (in particular, main body portion 33). For example, when vertical vibration or rotational vibration is transmitted to the printed board 31, the pedestal 38 suppresses relative swing (vibration) of the capacitor 32 with respect to the printed board 31. That is, the pedestal 38 is a vibration-proof member for the capacitor 32, and large swing due to vertical vibration or rotational vibration is suppressed by the pedestal 38 in principle.

The pedestal 38 has a through hole through which the lead portion 34 penetrates toward the printed board 31. A portion of the lead portion 34 exposed through the through hole is connected to the wiring pattern of the printed board 31. The pedestal 38 is integrated with the capacitor 32 and the printed board 31 when the capacitor 32 is attached to the printed board 31 at least. However, the pedestal 38 may be integrated with the capacitor 32 or the printed board 31 from the beginning.

Further, in the present embodiment, the adhesive 40 is applied or filled between the outer peripheral surface 35 of the capacitor 32 perpendicular to the surface of the printed board 31 and an inner peripheral surface 39 of the pedestal 38 perpendicular to the surface of the printed board 31. That is, the capacitor 32 and the pedestal 38 are adhered to each other by the adhesive 40 on the outer peripheral surface 35 of the capacitor 32 and the inner peripheral surface 39 of the pedestal 38. Accordingly, the swing (vibration) of the capacitor 32 is suppressed more firmly and reliably as compared to a case where the pedestal 38 supports the capacitor 32 without using the adhesive 40. As a result, breakage caused at a portion where stress is likely to concentrate due to swing (vibration) of the main body portion 33, such as a base end (connection end with main body portion 33) of the lead portion 34 or a connection portion with the printed board 31 is particularly reliably prevented.

However, the outer peripheral surface 35 of the capacitor 32 is adhered to the pedestal 38 not entirely but partially. Therefore, the explosion-proof valve 36 and a path of the gas leaking from the explosion-proof valve 36 are not completely sealed. As illustrated in FIG. 3, in the present embodiment, a right side surface of the capacitor 32 of the outer peripheral surface 35 is adhered to the pedestal 38 with the adhesive 40, but the left side surface is applied with the adhesive 40 and is opened. When the explosion-proof valve 36 is formed on the upper surface of the main body portion 33, or when the explosion-proof valve 36 is not provided due to the property of the capacitor 32, the outer peripheral surface 35 of the capacitor 32 may be entirely adhered to the pedestal 38.

In FIG. 3, the adhesive 40 for adhering the capacitor 32 and the pedestal 38 is filled in the entire range where the outer peripheral surface 35 of the capacitor 32 and the inner peripheral surface 39 of the pedestal 38 face each other at the adhesive portion. However, it is sufficient that the adhesive 40 for adhering the capacitor 32 and the pedestal 38 is filled in at least a part of the range where the outer peripheral surface 35 of the capacitor 32 and the inner peripheral surface 39 of the pedestal 38 face each other.

As illustrated in FIG. 3, the adhesive 40 for adhering the capacitor 32 and the pedestal 38 is not only filled in a space formed between the capacitor 32 and the pedestal 38, but also applied to a position higher than the pedestal 38 in the vertical direction. That is, the adhesive 40 is applied to a position higher than an upper surface 41 of the pedestal 38 along the outer peripheral surface 35 of the capacitor 32. Accordingly, the support performance of the capacitor 32 by the pedestal 38 is particularly improved, and the swing (vibration) of the capacitor 32 is suppressed more firmly and reliably.

The condition related to the application height of the adhesive 40 may be a condition that a contact area S₂ between the capacitor 32 and the adhesive 40 is larger than a contact area S₁ between the pedestal 38 and the adhesive 40. That is, the adhesive 40 is preferably applied so as to protrude from the pedestal 38. In a case where the contact area S₂ between the capacitor 32 and the adhesive 40 is larger than the contact area S₁ between the pedestal 38 and the adhesive 40 and the adhesive 40 protrudes from the pedestal 48, the pedestal 38 is substantially extended by the protruding adhesive 40. As a result, the support performance of the capacitor 32 by the pedestal 38 is particularly improved, and the swing (vibration) of the capacitor 32 is suppressed more firmly and reliably. Accordingly, in the present embodiment, the adhesive 40 protrudes from the pedestal 38 in the vertical direction (third direction Lo) as described above, but the adhesive 40 may protrude in the lateral direction (first direction La₁ or second direction La₂). Of course, the contact area S₂ between the capacitor 32 and the adhesive 40 may be larger than the contact area S₁ between the pedestal 38 and the adhesive 40 by causing the adhesive 40 to protrude in both the vertical direction and the lateral direction. In the present embodiment, the adhesive 40 for adhering the capacitor 32 and the pedestal 38 is applied so as to protrude from the pedestal 38 in the vertical direction, as illustrated in FIG. 3.

The adhesive 40 is made of any material. For example, a potting material or the coating agent 42 of the printed board 31 can be used as the adhesive 40. The coating agent of the printed board 31 forms an insulating film for preventing moisture and adhesion of foreign matter. In the present embodiment, the coating agent 42 of the printed board 31 is used as the adhesive 40.

FIG. 4 is a perspective view illustrating a typical configuration of the pedestal 38. As illustrated in FIG. 4, the pedestal 38 has a substantially rectangular bottom surface, and a first columnar portion 51a, a second columnar portion 51b, a third columnar portion 51c, and a fourth columnar portion 51d extending along the vertical direction of the capacitor 32 are respectively provided at four corners of the bottom surface. In the present embodiment, the columnar portions 51a to 51d all have the same height, but the height thereof is lower than the height of the capacitor 32. That is, the pedestal 38 supports the capacitor 32 at a part in the vertical direction by the columnar portions 51a to 51d. In the pedestal 38 having this shape, in principle, a portion (hereinafter, referred to as adhesive portion) to which the adhesive 40 may be filled or applied is one or a plurality of portions among portions corresponding to the respective columnar portions 51a to 51d. When the adhesive 40 is applied so as to protrude from the pedestal 38 in the vertical direction, the adhesive 40 may be applied to one or a plurality of portions of a first adhesive portion 52a corresponding to the first columnar portion 51a, a second adhesive portion 52b corresponding to the second columnar portion 51b, a third adhesive portion 52c corresponding to the third columnar portion 51c, and a fourth adhesive portion 52d corresponding to the fourth columnar portion 51d.

FIG. 5 is a view illustrating a relation between adjacent electronic components and an adhesive portion between the capacitor 32 and the pedestal 38. In the present embodiment, the coil 55 is disposed adjacent to the capacitor 32 on the printed board 31, as illustrated in FIG. 5.

In a case where the coating agent 42 or the adhesive 40 adheres, the coil 55 may not exhibit expected normal performance or function due to expansion or contraction caused by an applied current. Therefore, the coil 55 is usually an electronic component in which application of the coating agent 42 or the like is prohibited. Therefore, when the coil 55 is disposed adjacent to the capacitor 32, the adhesive 40 is selectively applied to a portion opposite to the coil 55. Specifically, when the coil 55 is attached adjacent to the capacitor 32 on the printed board 31, the capacitor 32 is not adhered to the pedestal 38 on a side surface of the outer peripheral surface 35 facing the coil 55, and the capacitor 32 is adhered to the pedestal 38 on a side surface of the outer peripheral surface 35 not facing the coil 55. In FIG. 5, among the adhesive portions 52a to 52d, the adhesive 40 is not applied to the second adhesive portion 52b and the third adhesive portion 52c which are relatively close to the coil 55, and the adhesive 40 is applied to the first adhesive portion 52a and the fourth adhesive portion 52d which are relatively distant from the coil 55.

An adhesive portion to which the adhesive 40 is to be applied or the like is selected as follows, for example. As illustrated in FIG. 5, a line connecting a center C₁ of the capacitor 32 and a center C₂ of the coil 55 on the surface of the printed board 31 is defined as a center line CL. In this case, a straight line (hereinafter, referred to as division line DL) passing through the center C₁ of the capacitor 32 and perpendicular to the center line CL divides the capacitor 32 into a first region A₁ distant from the coil 55 and a second region A₂ close to the coil 55. Therefore, the adhesive 40 is applied to the first adhesive portion 52a and the fourth adhesive portion 52d which belong to the first region A₁ distant from the coil 55. Accordingly, breakage of the capacitor 32 is prevented without impairing the performance and function of the coil 55.

In FIG. 5, the coil 55 is illustrated as a representative example of the electronic component in which the adhesion of the adhesive 40 (coating agent 42) is prohibited, but the present invention is not limited thereto. Even when an electronic component that needs to ensure electrical conduction performance or the like, such as a connector that connects the electronic circuit 23 to an external circuit or the like, is disposed adjacent to the capacitor 32, the adhesive 40 is selectively applied to a portion opposite to the electronic component as described above. That is, when an electronic component to which the adhesion of the adhesive 40 is prohibited is disposed adjacent to the capacitor 32 in order to ensure the function and the performance, the application portion of the adhesive 40 is selected so that the adhesive 40 does not adhere to the electronic component as described above.

FIG. 6 is a sectional view of the first drive unit 11 illustrating a positional relation between the third fastening point 22C and the capacitor 32. In FIG. 6, the third fastening point 22C is indicated by an asterisk. As illustrated in FIG. 6, when the inverter 16 is disposed to be inclined with respect to the horizontal direction, the capacitor 32 adhered to the pedestal 38 is preferably disposed on the vertical line VL or in the vicinity of the vertical line VL as much as possible in a lateral cross section in the direction (XZ cross section perpendicular to Y direction) of the electric vehicle 100. The vertical line VL is a straight line parallel to the vertical direction (Z direction) passing through the third fastening point 22C serving as a transmission start point of vertical vibration and rotational vibration to the electronic circuit 23.

In this manner, when the capacitor 32 is disposed on the vertical line VL of the third fastening point 22C serving as the transmission starting point of the vibration, a moment generated in the capacitor 32 by the vertical vibration due to the road surface is the smallest. Therefore, when the capacitor 32 is located on the vertical line VL of the third fastening point 22C, the capacitor 32 is at least less likely to swing with respect to the vertical vibration due to the road surface. Accordingly, breakage caused at a portion where stress is likely to concentrate due to swing (vibration) of the main body portion 33, such as a base end (connection end with main body portion 33) of the lead portion 34 or a connection portion with the printed board 31 is particularly reliably prevented.

The same applies to a case where vibration is transmitted from another fastening point of the inverter 16 to the electronic circuit 23. For example, when vibration is mainly transmitted from the second fastening point 22B to the electronic circuit 23, the capacitor 32 adhered to the pedestal 38 is preferably disposed on the vertical line VL passing through the second fastening point 22B or in the vicinity of the vertical line VL as close as possible.

However, since the vertical vibration is input from below the electric vehicle 100 (road surface), when there are a plurality of fastening points, it is particularly preferable that the capacitor 32 adhered to the pedestal 38 is located vertically above a fastening point that is located vertically below among the fastening points. That is, as illustrated in FIG. 6, it is particularly preferable that the capacitor 32 adhered to the pedestal 38 is located vertically above the third fastening point 22C which is a lower fastening point.

In the above embodiment, the structure of the capacitor 32 included in the inverter 16 of the first drive unit 11 has been described, and the structure of the capacitor 32 according to the above embodiment is also suitable for a capacitor included in the inverter 20 of the second drive unit 12. That is, even in the inverter 20 disposed substantially horizontally (parallel to road surface), the capacitor 32 adhered to the pedestal 38 on the outer peripheral surface 35 is preferably used. In this case, the lead portion 34 of the capacitor 32 is less likely to be broken by the vertical vibration or the rotational vibration.

In the above embodiment, the capacitor 32 adhered to the pedestal 38 on the outer peripheral surface 35 is used in the inverter 16 for driving the electric motor 14, but the present invention is not limited thereto. For example, the capacitor 32 adhered to the pedestal 38 on the outer peripheral surface 35 is also suitable for an electronic unit other than the inverter 16. The electric vehicle 100 may include a generator in addition to the electric motor 14. The capacitor 32 adhered to the pedestal 38 on the outer peripheral surface 35 is also suitable for an inverter for driving such a generator. That is, the capacitor 32 adhered to the pedestal 38 on the outer peripheral surface 35 may be used in an inverter that drives the electric motor 14 or a rotating electric machine that is a generator.

As described above, the electronic unit (inverter 16) according to the present embodiment is an electronic unit to be mounted on a vehicle (electric vehicle 100). The electronic unit includes: the printed board 31 to which a plurality of electronic components are attached; the capacitor 32 which is one of the electronic components and is longer in a vertical direction perpendicular to a surface of the printed board 31 than in a lateral direction parallel to the surface of the printed board 31 in a state of being attached to the printed board 31; and the pedestal 38 interposed between the capacitor 32 and the printed board 31 and configured to support the capacitor 32. The capacitor 32 and the pedestal 38 are adhered by the adhesive 40 on the outer peripheral surface 35 of the capacitor 32 and the inner peripheral surface 39 of the pedestal 38 which are perpendicular to the surface of the printed board 31.

In an electronic unit such as the inverter 16 to be mounted on the electric vehicle 100, the capacitor 32 which is tall swings in a case where vertical vibration or rotational vibration is input, and the lead portion 34 may be broken. Therefore, vibration of the capacitor 32 which is tall is usually suppressed by interposing the pedestal 38. However, the lead portion 34 may be broken due to the swing of the capacitor 32 even when the main body portion 33 is supported by the pedestal 38, depending on an attachment position of the capacitor 32 or the like. Therefore, the capacitor 32 and the pedestal 38 are adhered using the adhesive 40 as described above. Accordingly, breakage of the capacitor 32 is more reliably prevented even when vertical vibration or rotational vibration is input.

In the electronic unit (inverter 16) according to the above-described embodiment, at least a part of the printed board 31 is coated with the coating agent 42, and the coating agent 42 is used as the adhesive 40. In this manner, in a case where the coating agent 42 of the printed board 31 is used as the adhesive 40 for adhering the capacitor 32 and the pedestal 38, the capacitor 32 and the pedestal 38 can be adhered when the coating agent 42 is applied to the printed board 31. Therefore, it is possible to easily and reliably prevent swing and breakage of the capacitor 32. There is a secondary effect of preventing the capacitor 32 from swinging and breaking at a low cost by using the coating agent 42 as the adhesive 40.

In the electronic unit (inverter 16) according to the above-described embodiment, the capacitor 32 is adhered to the pedestal 38 at a part of the outer peripheral surface 35. In this manner, the explosion-proof valve 36 of the capacitor 32 is not blocked by adhering a part of the outer peripheral surface 35 of the capacitor 32 and the inner peripheral surface 39 of the pedestal 38, rather than adhering the whole part of the outer peripheral surface 35 of the capacitor 32 and the inner peripheral surface 39 of the pedestal 38, and a path for gas leaking from the explosion-proof valve 36 in an emergency is secured. Therefore, the swing and breakage of the capacitor 32 are prevented while maintaining the safety function.

In the electronic unit (inverter 16) according to the above-described embodiment, another electronic component (coil 55 or connector) which is an electronic component different from the capacitor 32 is attached adjacent to the capacitor 32 on the printed board 31. The capacitor 32 is not adhered to the pedestal 38 on a side surface of the outer peripheral surface 35 facing the other electronic component (coil 55 or connector), and the capacitor 32 is adhered to the pedestal 38 on a side surface of the outer peripheral surface 35 not facing the other electronic component (coil or connector).

In the electronic unit (inverter 16) according to the above-described embodiment, the pedestal 38 supports the capacitor 32 at a part in the vertical direction. The adhesive 40 fills a space formed between the capacitor 32 and the pedestal 38, and is applied to a position higher than the pedestal 38 in the vertical direction. In this manner, the adhesive 40 is applied so as to protrude from the pedestal 38, so that the pedestal 38 is substantially extended by the protruding adhesive 40. As a result, the support performance of the capacitor 32 by the pedestal 38 is particularly improved, and further, the swing and breakage of the capacitor 32 are reliably suppressed.

In the electronic unit (inverter 16) according to the above-described embodiment, the contact area S₂ between the capacitor 32 and the adhesive 40 is larger than the contact area S₁ between the pedestal 38 and the adhesive 40. In this manner, the pedestal 38 is substantially extended by the protruding adhesive 40 by making the contact area S₂ between the capacitor 32 and the adhesive 40 larger than the contact area S₁ between the pedestal 38 and the adhesive 40. As a result, the support performance of the capacitor 32 by the pedestal 38 is particularly improved, and further, the swing and breakage of the capacitor 32 are reliably suppressed.

In the electronic unit (inverter 16) according to the above-described embodiment, the pedestal 38 includes a plurality of columnar portions (51a to 51d) supporting the capacitor 32. The capacitor 32 is adhered to the pedestal 38 on at least one columnar portion (51a to 51d). Since the columnar portions (51a to 51d) of the pedestal 38 have a structure for suppressing the swing of the capacitor 32, the swing and breakage of the capacitor 32 are suppressed particularly easily and reliably by adhering the capacitor 32 and the pedestal 38 on the columnar portions (51a to 51d) as described above.

In particular, the electronic unit according to the above-described embodiment constitutes the inverter 16 that drives the rotating electric machine (electric motor 14), and the inverter 16 is fastened to the rotating electric machine (electric motor 14) so as to be inclined from the horizontal direction. The capacitor 32 is located on the vertical line VL passing through a fastening point (22C) of the inverter 16 with respect to the rotating electric machine (electric motor 14) in a lateral cross section (XZ cross section perpendicular to Y direction) of the vehicle (electric vehicle 100). In this manner, when the electronic unit (inverter 16) is disposed to be inclined, a moment generated in the capacitor 32 due to the vertical vibration is reduced in a case where the capacitor 32 adhered to the pedestal 38 is located on the vertical line VL passing through the fastening point (22C), and thus the capacitor 32 is less likely to swing with respect to the vertical vibration. Accordingly, swing and breakage of the capacitor 32 is more reliably prevented.

In the electronic unit (inverter 16) according to the above-described embodiment, when there are a plurality of fastening points (22A to 22D), the capacitor 32 is located vertically above a fastening point (22C) which is relatively vertically below among the fastening points (22A to 22D). Since the vertical vibration is input from below the electric vehicle 100, the swing and breakage of the capacitor 32 due to the vertical vibration are particularly easily prevented by the capacitor 32 adhered to the pedestal 38 being located vertically above a lower fastening point (third fastening point 22C) as described above.

Although the embodiment of the present invention has been described above, configurations described in the above embodiment and the modifications are only a part of application examples of the present invention, and are not intended to limit the technical scope of the present invention.

For example, the capacitor 32 adhered to the pedestal 38 on the outer peripheral surface 35 is suitable for vehicles other than the electric vehicle 100, such as a two-wheel drive vehicle and a hybrid vehicle. In an electronic unit other than a vehicle to which any vibration may be input, the capacitor 32 adhered to the pedestal 38 on the outer peripheral surface 35 is suitable. The inverter 16 of the first drive unit 11 is fastened to the electric motor 14 so as to be inclined forward, and the inclination direction of the inverter 16 is any direction. Although the inverter 16 is fastened to the electric motor 14, the inverter 16 may be fastened to the speed reducer 15 or other rigid bodies. In this manner, the structure and the like not related to the capacitor 32 may be optionally changed.

## Claims

1. An electronic unit to be mounted on a vehicle, the electronic unit comprising:
a printed board to which a plurality of electronic components are attached;
a capacitor which is one of the electronic components and is longer in a vertical direction perpendicular to a surface of the printed board than in a lateral direction parallel to the surface of the printed board in a state of being attached to the printed board; and
a pedestal interposed between the capacitor and the printed board and configured to support the capacitor, wherein
the capacitor and the pedestal are adhered by an adhesive on an outer peripheral surface of the capacitor and an inner peripheral surface of the pedestal which are perpendicular to the surface of the printed board.

2. The electronic unit according to claim 1, wherein
at least a part of the printed board is coated with a coating agent, and
the coating agent is used as the adhesive.

3. The electronic unit according to claim 1, wherein
the capacitor is adhered to the pedestal at a part of the outer peripheral surface.

4. The electronic unit according to claim 3, wherein
another electronic component which is the electronic component different from the capacitor is attached adjacent to the capacitor on the printed board, and
the capacitor is not adhered to the pedestal on a side surface of the outer peripheral surface facing the other electronic component, and the capacitor is adhered to the pedestal on a side surface of the outer peripheral surface not facing the other electronic component.

5. The electronic unit according to claim 1, wherein
the pedestal supports the capacitor at a part in the vertical direction, and
the adhesive fills a space formed between the capacitor and the pedestal, and is applied to a position higher than the pedestal in the vertical direction.

6. The electronic unit according to claim 1, wherein
a contact area between the capacitor and the adhesive is larger than a contact area between the pedestal and the adhesive.

7. The electronic unit according to claim 1, wherein
the pedestal includes a plurality of columnar portions configured to support the capacitor, and
the capacitor is adhered to the pedestal on at least one of the columnar portions.

8. The electronic unit according to claim 1, wherein
the electronic unit is an inverter configured to drive a rotating electric machine,
the inverter is fastened to the rotating electric machine to be inclined from a horizontal direction, and
the capacitor is located on a vertical line passing through a fastening point of the inverter to the rotating electric machine in a lateral cross section of the vehicle.

9. The electronic unit according to claim 8, wherein
when there are a plurality of the fastening points, the capacitor is located vertically above a fastening point that is located relatively vertically below among the fastening points.
